(19) Europäisches Patentamt
European Patent Office
Office européen des brevets

(11) **EP 2 909 671 B1**

(12) **FASCICULE DE BREVET EUROPEEN**

(45) Date de publication et mention de la délivrance du brevet:
**07.12.2016 Bulletin 2016/49**

(21) Numéro de dépôt: **13780186.6**

(22) Date de dépôt: **09.10.2013**

(51) Int Cl.:
***G02B 27/00*** $^{(2006.01)}$

(86) Numéro de dépôt international:
**PCT/FR2013/000267**

(87) Numéro de publication internationale:
**WO 2014/060657 (24.04.2014 Gazette 2014/17)**

(54) **PROCEDE DE CONCEPTION D'UN IMAGEUR MONOVOIE PASSIF CAPABLE D'ESTIMER LA PROFONDEUR DE CHAMP**

VERFAHREN ZUM AUSLEGEN EINER EINZELPFAD-KAMERA ZUR BESTIMMUNG DER TIEFENSCHÄRFE

METHOD FOR DESIGNING A SINGLE-PATH IMAGER ABLE TO ESTIMATE THE DEPTH OF FIELD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.10.2012 FR 1202774**

(43) Date de publication de la demande:
**26.08.2015 Bulletin 2015/35**

(73) Titulaire: **Office National d'Etudes et de Recherches Aérospatiales (ONERA) 91120 Palaiseau (FR)**

(72) Inventeurs:
• **TROUVE, Pauline 91120 Palaiseau (FR)**
• **CHAMPAGNAT, Frédéric 94160 Saint Mande (FR)**
• **LE BESNERAIS, Guy 94230 Cachan (FR)**
• **DRUART, Guillaume 91120 Palaiseau (FR)**

(74) Mandataire: **IP Trust 2, rue de Clichy 75009 Paris (FR)**

(56) Documents cités:
**EP-A1- 1 734 746**

• **A. N. RAJAGOPALAN AND S. CHAUDHURI: "Performance analysis of maximum likelihood estimator for recovery of depth from defocused images and optimal selection of camera parameters", INTERNATIONAL JOURNAL OF COMPUTER VISION, vol. 30, no. 3, 31 décembre 1998 (1998-12-31), pages 175-190, XP055058663, ISSN: 0920-5691, DOI: 10.1023/A:1008019215914**
• **A. LEVIN ET AL: "Image and depth from a conventional camera with a coded aperture", ACM TRANSACTIONS ON GRAPHICS (TOG), ACM, US, vol. 26, no. 3, 1 juillet 2007 (2007-07-01), pages 70-1-70-9, XP002622004, ISSN: 0730-0301, DOI: 10.1145/1239451.1239521**

**Description**

Domaine de l'invention

La présente invention concerne le domaine de l'estimation de la profondeur avec un système électro-optique monovoie passif, et plus précisément les procédés de conception d'un tel système électro-optique.
Les applications de tels systèmes électro-optiques concernent notamment le domaine de la défense où le développement d'appareils autonomes tels que les drones, a rendu nécessaire le développement de techniques d'extraction d'information 3D sur l'environnement de ces appareils.
De plus les nouvelles fonctionnalités associées à des technologies grand public, telles que le téléphone portable intelligent ou les consoles de jeu interactives, utilisent de plus en plus souvent une connaissance de l'environnement 3D autour de l'utilisateur.
Dans ces deux domaines d'application, les contraintes propres à des systèmes embarqués imposent la conception de systèmes compacts et peu coûteux en énergie.
Tous les appareils cités ont comme point commun d'embarquer au moins un système électro-optique passif (caméra).
L'objet de l'invention concerne l'estimation passive de la profondeur en exploitant uniquement les données fournies par le système électro-optique ce qui est donc la méthode la moins gourmande en énergie et en encombrement, pour adjoindre à l'appareil une capacité 3D.

Etat de la technique

On connaît dans l'état de la technique des procédés d'estimation de distance monovoie.
Le brevet américain US7711201 décrit un procédé et système électro-optique pour générer une carte de profondeur en utilisant une lentille mobile, un capteur d'images et un module de traitement couplé au capteur d'image pour déterminer les informations de profondeur. La lentille, le capteur d'images et le module de traitement forment un dispositif d'imagerie, tel qu'une caméra, utilisé pour capturer une image d'une scène pour des applications telles que la mise au point automatique, la surveillance ou la navigation de véhicule autonome. Un procédé de calcul des informations de profondeur comporte une étape de simulation d'une quantité de flou gaussien en utilisant un noyau de convolution, puis une estimation de la différence de flou entre les images.
L'article de A. Levin, R. Fergus, F. Durand et W.T. Freeman, « Image and depth from a conventional camera with a coded aperture ACM Transactions on Graphics », SIGGRAPH 2007 (http://groups.csail.mit.edu/graphics/CodedAperture/CodedApert ure-LevinEtAl-SIGGRAPH07.pdf) décrit une solution d'estimation de distance à partir d'un système électro-optique monovoie mettant en oeuvre un diaphragme codé. Il décrit aussi une méthode d'optimisation du codage de ce diaphragme.
Le brevet français FR2880958 décrit un système électro-optique d'accroissement de la profondeur de champ. Une des variantes décrites dans ce brevet concerne la réalisation d'un procédé et système adaptée à la mesuré de la distance des objets d'une scène à partir d'une seule acquisition sans nécessité d'un dispositif matériel de mesure de télémétrie. Le procédé permet alors d'obtenir une estimation de distance des objets présents dans chaque région de l'image numérique.
La solution proposée dans ce document de l'art antérieur consiste à utiliser une optique chromatique, ce qui permet d'avoir un niveau de netteté variable selon les canaux rouge vert et bleu de l'acquisition, et de décomposer l'image numérique en zones de X par Y pixels. On mesure alors pour chaque zone la netteté d'au moins deux canaux, on reporte alors les valeurs mesurées, ou les valeurs relatives mesurées, sur des courbes de netteté en fonction de la distance, courbes définies par exemple par calibration de l'appareil de capture. On obtient alors une distance correspondant à une estimation de la profondeur de la partie de l'objet représentée sur la zone de l'appareil de capture dans le repère de l'appareil.
Ce procédé permet d'obtenir une estimation de distance des objets présents dans chaque région de l'image numérique, afin de construire un dispositif télémètre temps réel et bas coût à l'aide d'un capteur et d'une optique standard qui délivre une image et des informations de distance corrélées à l'image.
On connaît aussi la demande internationale WO2009082822 décrivant un procédé permettant de générer une carte de profondeur en utilisant une seule caméra, en sélectionnant la meilleure métrique de mise au point parmi les informations de métrique de mise au point à partir de multiples images capturées. La meilleure métrique permet de définir la position optimale de la lentille et d'en déduire la profondeur. Ce procédé de l'art antérieur utilise la carte de profondeur générée pour effectuer une opération de traitement d'image, permettant par exemple de régler l'intensité du flash, de refocaliser l'image sur un plan de profondeur d'intérêt ou d'aider à la génération d'une image couleur.
La demande internationale WO2007022329 décrit un autre exemple de système d'acquisition d'imagerie donnant une carte de profondeur à partir de deux images d'une scène spatiale tridimensionnelle sur la base du flou relatif entre les deux images et le flou absolu produit par ledit système, calculant la carte de profondeur directement à partir du flou relatif entre les deux images et calculant une distance à partir de la valeur de rayon de flou associée.

La demande de brevet américain US2009268985 décrit un système d'imagerie générant une carte de profondeur d'image à partir d'une paire d'images de résolution réduite, calculant une différence de flou entre les deux images de résolution réduite à différents emplacements d'image et calculant la carte de profondeur basée sur la différence de flou entre les deux images de résolution réduite à différents emplacements d'image.

On connaît d'autre part le brevet européen délivré EP1734746 décrivant une méthode d'optimisation d'un système électro-optique basée sur un critère de performance relatif à la qualité de l'image. Ce brevet décrit plus précisément un procédé informatique de conception d'un système d'imagerie électro-optique constitué par :

- des composants optiques
- un détecteur électro-optique et les circuits associés
- les moyens de traitement numérique.

Ce procédé de l'art antérieur est basé sur un modèle spatial de la source. Le procédé inclut des étapes de conception conjointe simultanée et non pas séquentielle, des sous-systèmes optiques et de traitement d'image, basé sur une métrique de performance de post-traitement qui est fonction d'une comparaison d'une image numérique calculée par le système d'imagerie par la modélisation avec une image numérique idéale de la source.

On connaît l'article de A.Rajagopalan et S.Chaudhuri, «Performance analysis of maximum likelihood estimator for recovery of depth from defocused images and optimal selection of camera parameters», International Journal of Computer Vision, Springer, 1998, 30, p. 175-190 qui présente une méthode d'optimisation du rapport des flous de deux images utilisées pour estimer la profondeur. Cette optimisation repose sur un critère de performance d'estimation de profondeur qui est la borne de Cramér-Rao calculée en utilisant une modélisation du flou par une gaussienne et un modèle paramétrique de la source.

Inconvénients des solutions de l'art antérieur

Les différentes solutions connues dans l'état de la technique ne permettent pas d'optimiser le système électro-optique monovoie en fonction des caractéristiques des sous-ensembles optiques, détecteurs et traitements d'image, pour l'estimation de la profondeur.

En particulier, la solution proposée par l'article de A. Levin propose une optimisation du codage du diaphragme à partir d'un critère ne renseignant pas sur la précision d'estimation de profondeur obtenue. De plus l'optimisation concerne uniquement le diaphragme et non l'ensemble du système optique.

Le brevet français FR2919732 prend en compte une variation du chromatisme, mais l'effet sur la précision de l'estimation de la profondeur n'est pas décrit.

Le brevet européen EP1734746 décrit un procédé d'optimisation ne permettant pas d'améliorer la précision de l'estimation de la distance, mais seulement la qualité de l'image.

La solution proposée par l'article de A.Rajagopalan ne permet pas d'optimiser un système électro-optique ayant un diaphragme codé car ce type de système optique ne répond pas à l'hypothèse de flou gaussien. De plus, elle permet uniquement l'optimisation d'un système électro-optique multivoie ou éventuellement un système électro-optique monovoie avec un mode d'acquisition séquentielle, ceci afin d'obtenir plusieurs acquisitions de la même scène.

En synthèse, les solutions de l'art antérieur ne permettent pas d'optimiser un système électro-optique en fonction du degré de précision de l'estimation de la profondeur et des conditions d'acquisition des images, pour un système électro-optique monovoie.

Solution apportée par l'invention

La présente invention vise à remédier aux inconvénients de l'art antérieur, en proposant un procédé d'optimisation d'un système électro-optique permettant d'améliorer la précision de l'estimation de la distance de la source en tenant compte des conditions d'acquisitions de la scène.

Le but est de prendre en compte l'estimation de la profondeur dès la conception du système électro-optique, afin d'optimiser et de garantir la performance, suivant les besoins de l'utilisateur.

L'invention propose un nouveau procédé de conception d'un système électro-optique monovoie passif capable d'estimer la profondeur, avec une adaptation à un besoin de l'utilisateur en termes de précision d'estimation et de condition d'utilisation.

A cet effet, l'invention concerne selon son acception la plus générale un procédé mis en oeuvre par ordinateur pour la conception d'un système d'imagerie électro-optique pour estimer la distance d'une source, incluant un sous-système optique, un sous-système de détecteur et un sous-système de traitement d'image numérique, le procédé incluant la modélisation de la propagation d'un rayonnement depuis sa source par l'intermédiaire du sous-système optique, du sous-système de détecteur et du sous-système de traitement d'image numérique, la modélisation étant basée sur un modèle spatial de la source, le procédé incluant une étape de conception conjointe simultanément du sous-système optique et du système de traitement d'image numérique. L'étape de conception est basée au moins sur une métrique de performance fonction d'une comparaison entre l'estimation locale de la distance de la source et la distance réelle de la source.

Au sens du présent brevet, les termes de « profondeur » et de « distance » ont la même signification technique.

De préférence, la profondeur désigne la distance mesurée sur l'axe optique entre :

- l'intersection entre l'axe optique et le plan orthogonal passant par la source, et
- l'intersection entre l'axe optique et la pupille d'entrée, ou tout point de référence de la caméra

De préférence, la distance est mesurée ou estimée entre un point source et un point d'arrivée. Le point source correspond aux coordonnées d'une source ponctuelle. On peut avoir une collection de sources ponctuelles formant une source étendue. On peut prendre alors le barycentre de la collection de sources ponctuelles ; le point d'arrivée est notamment le point central de la pupille d'entrée, ou tout autre point de référence de la caméra.

Domaine d'application

L'invention s'applique lorsque l'on procède à l'acquisition d'une image ayant une unique mise au point mais également, lorsque l'on procède à l'acquisition simultanée, avec des mises au point différentes, et au traitement d'une pluralité d'images.

Avantageusement, ladite pluralité d'images est obtenue avec un détecteur constitué d'une pluralité de matrices de capteurs sensibles chacune à une bande spectrale spécifique, chacune des images correspondant à l'une desdites bandes spectrales.

Selon un mode de réalisation particulier, le système électro-optique présente des moyens d'ajustement d'une mise au point spécifique pour chacune des dites bandes spectrales.

Selon une variante particulière, le sous-système optique inclut un diaphragme codé apte à minimiser l'écart entre la distance estimée et la distance réelle sur un catalogue d'images, le procédé comportant des étapes de variation du codage dudit diaphragme et de détermination de l'écart en découlant.

Selon une variante particulière, la métrique caractérisant la précision d'estimation de profondeur peut être associée à une autre métrique, comme par exemple, une métrique caractérisant la netteté ou la capacité à produire une image de grande profondeur de champ.

Description détaillée d'un exemple de réalisation non limitatif

La présente invention sera mieux comprise à la lecture de la description détaillée d'un exemple de mise en oeuvre non limitatif qui suit, se référant aux dessins annexés, où :

- la figure 1 représente le schéma de principe des différents blocs fonctionnels d'un système électro-optique monovoie passif estimant la profondeur selon l'état de la technique
- la figure 2 représente le schéma de principe du procédé d'aide à la conception proposée
- la figure 3 représente la courbe des précisions d'estimation théorique obtenues en utilisant un calcul de performance d'estimation de profondeur pour deux systèmes optiques de même focale et de même ouverture mais de forme de diaphragme différente
- la figure 4 représente la courbe des précisions d'estimation théorique obtenues en utilisant un calcul de performance d'estimation de profondeur pour deux mises au point différentes du même système optique.
- la figure 5 représente la courbe des précisions d'estimation théorique obtenues en utilisant un calcul de performance d'estimation de profondeur pour deux systèmes optiques chromatiques ayant des positions des plans de mise au point des canaux rouge, vert et bleu différentes.
- la figure 6 représente les lentilles constituant un système électro-optique optimisé pour favoriser l'estimation de la profondeur.
- la figure 7 présente un tableau des caractéristiques des lentilles du système électro-optique représenté à la figure 6.
- la figure 8 représente la courbe des précisions d'estimation théorique obtenues en utilisant un calcul de performance d'estimation de profondeur pour le système électro-optique représenté dans les figures 6 et 7.

Description des paramètres du système électro-optique

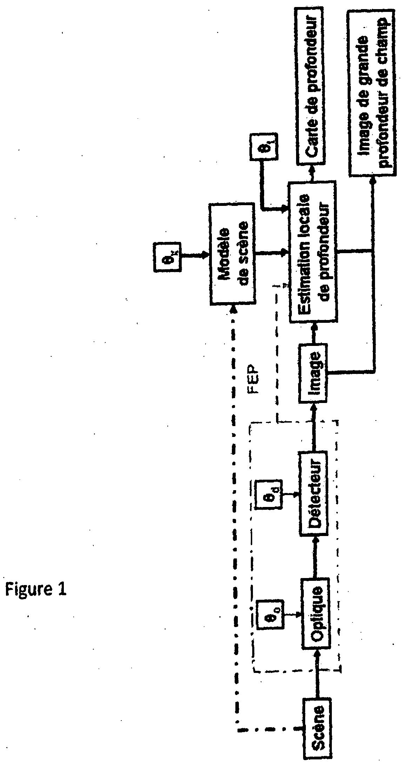

La figure 1 représente le schéma de principe des différents blocs fonctionnels d'un système électro-optique monovoie passif estimant la profondeur selon l'état de la technique.

Il comprend de façon connue un détecteur, par exemple un capteur CCD associé à un sous-système optique, et un sous-système de traitement des signaux.

Le sous-système optique est caractérisé par des paramètres notés θo qui correspondent typiquement à :

- la focale
- l'ouverture
- aux caractéristiques des lentilles constituant l'optique (nombre, rayon de courbure, diamètre, conicité, nature du verre).
- le champ.

Le détecteur est caractérisé par les paramètres θd qui correspondent typiquement à la taille des pixels, leur nombre, ou à d'autres caractéristiques comme le temps d'exposition ou par exemple la présence possible d'un filtre de Bayer. L'ensemble optique et détecteur forme l'image de la scène qui va être utilisée pour l'estimation de profondeur.

La partie traitement du système électro-optique utilise les paramètres de la fonction d'étalement de point et de scène, ainsi que des paramètres de traitement notés θt qui correspondent par exemple à la taille des vignettes de l'image.

Dans l'estimation de profondeur interviennent les paramètres du modèle de la source, qui sont représentés par θx. L'hypothèse sur la source correspond par exemple à un modèle local des contrastes observables par le système électro-optique (textures, contours, etc.)

Paramètres intervenant dans la précision d'estimation de profondeur

La précision d'estimation de profondeur dépend tout d'abord de la variabilité de la Fonction d'Etalement de Point (FEP) avec la profondeur. Cette dernière dépend des paramètres optiques et détecteurs θo et θd. Ensuite, la précision dépend du paramètre θt caractérisant notamment le nombre de pixels de chaque vignette utilisée pour estimer la profondeur.

En outre certains paramètres influençant l'estimation de profondeur relèvent des conditions d'utilisation du système électro-optique. Il s'agit d'une part du niveau de bruit qui affecte les images, qui est largement lié aux conditions d'illumination dans lesquelles l'appareil est utilisé. Ce niveau de bruit est défini ici par le Rapport Signal-à-Bruit (RSB). D'autre part des caractéristiques de la scène observée par l'appareil, sont décrites par les paramètres du modèle de la source, θx.

Ainsi, la précision d'estimation de profondeur d'un système électro-optique dépend à la fois des paramètres optiques et capteur θd et θc), des paramètres traitement (θt) et des conditions d'utilisation et du modèle de la source (RSB, θx).

Description d'un exemple de procédé de conception d'un système électro-optique monovoie

La conception d'un système électro-optique estimant la profondeur nécessite l'optimisation conjointe de tous les paramètres qui influencent la précision d'estimation en fonction des exigences de l'utilisateur en termes de gabarit de précision et des conditions d'utilisation.

Soit un utilisateur définissant par exemple le champ du système électro-optique, le RSB, l'encombrement maximal du système électro-optique ainsi que la précision désirée sur une plage de profondeur.

Un exemple de procédé de conception suivant l'invention proposée consiste à :

- prendre un système électro-optique initial approchant les conditions d'utilisations imposées par l'utilisateur dans une bibliothèque de systèmes électro-optiques
- modéliser un ensemble de FEP relatives à ce système, soit par des fonctions mathématiques simples, soit en utilisant des formules d'optique ondulatoire, soit en utilisant un logiciel de conception optique
- calculer la métrique de précision d'estimation de profondeur
- comparer le résultat avec le gabarit imposé par l'utilisateur
- effectuer une boucle de rétroaction introduisant des modifications successives des paramètres optique, détecteur et traitement avec à chaque modification une comparaison de la métrique avec le gabarit
- sélectionner le système électro-optique approchant au mieux le gabarit pour renvoyer à l'utilisateur les paramètres optimisés.

Avantageusement, si plusieurs systèmes électro-optiques vérifient lés conditions imposées par l'utilisateur, ce dernier peut se voir proposé plusieurs solutions ou la possibilité de donner plus de contraintes afin de réoptimiser le système.

A l'inverse, si les conditions imposées sont trop sévères et n'aboutissent pas à l'optimisation d'un système électro-optique, l'utilisateur pourra en être informé afin qu'il réduise ses contraintes.

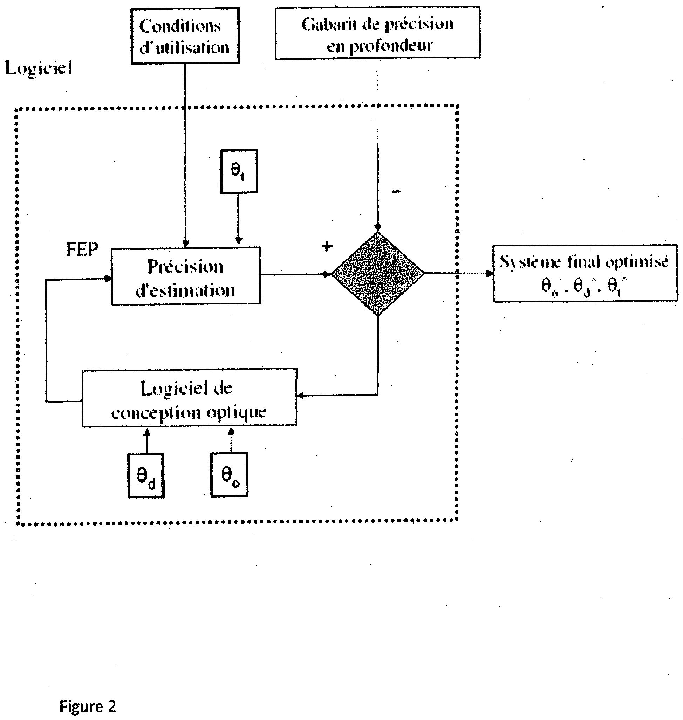

Le procédé décrit précédemment est représenté à la figure 2.

Evaluation de la précision d'estimation

Avantageusement, la métrique de précision d'estimation de profondeur est calculée par une moyenne probabiliste du comportement de l'écart entre la distance estimée et la distance réelle sur un catalogue d'images.

Classiquement, cet écart est caractérisé par le calcul de la courbure moyenne de la fonction de vraisemblance, vis-à-vis de la profondeur, pour un catalogue d'images. Cette fonction de vraisemblance est calculée suivant les étapes suivantes :

- enregistrement d'une bibliothèque de fonctions d'étalement de point (FEP), chacune desdites fonctions FEP associée à une profondeur et à un système électro-optique ;
- capture d'au moins une image réelle, ou modélisation d'au moins une image à l'aide d'une des FEP de la bibliothèque de FEP ;
- division de ladite (ou desdites) image(s) en vignette(s) de taille prédéfinie pour enregistrer une collection de vignettes;
- calcul de la vraisemblance de chaque FEP, vis-à-vis du contenu des vignettes et estimation pour chacune desdites vignettes de la FEP qui maximise cette vraisemblance;
- mesure de la courbure locale du critère de vraisemblance autour de la FEP qui maximise la fonction de vraisemblance.

La mesure de cette courbure fournit une valeur représentative de l'écart entre la distance estimée et la distance réelle, désignée par le terme de borne de Cramér-Rao (BCR).

Selon une variante avantageuse, la précision d'estimation de profondeur est calculée sans qu'il soit nécessaire d'acquérir ou de simuler un catalogue d'images, grâce à l'utilisation d'un modèle spatial de la source.

Selon une variante particulière, le modèle spatial de la source est une densité spectrale de puissance. Cette modélisation est notamment utilisée dans le brevet EP1734746 cité dans l'état de l'art.

Selon une variante particulière, la source est modélisée à l'aide de la matrice de covariance apprise sur une base d'images.

Selon une variante particulière, la source est modélisée à l'aide de la matrice de précision, correspondant à l'inverse de la matrice de covariance, fondée sur une hypothèse de distribution isotrope et gaussienne des gradients de la source. Soit Qx la matrice de précision, une variante avantageuse consiste à écrire :

$$Q_x \propto \frac{D^T D}{\sigma_x^2} \qquad (1)$$

Où D correspond à la concaténation d'un opérateur de dérivation d'ordre 1 horizontal et vertical et $\sigma_x^2$ est un paramètre caractérisant la variance des gradients de la source.

Selon un mode de calcul particulier, si Hp est la matrice de convolution associée à la FEP de la profondeur p, la modélisation de la source à l'aide de la matrice de précision permet d'écrire la BCR de la manière suivante :

$$BCR(p) = \left[ tr\left( Q_p^{-1} \frac{dQ_p}{dp} Q_p^{-1} \frac{dQ_p}{dp} \right) \right]^{-1} \qquad (2)$$

La grandeur caractérisant la précision d'estimation de profondeur est alors $\sigma_{BCR}(p)$ qui est la racine carrée de BCR(p).

$$Q_P = R_b^{-1}(I - H_p(H_p^T R_b^{-1} H_p + Q_x)^{-1} H_p^T R_b^{-1}) \quad (3)$$

Où Rb est la matrice de covariance du bruit et Qp la matrice de précision des données.

Dans un cas particulier, le bruit peut être modélisé comme un processus aléatoire de densité de probabilité blanc et gaussienne de variance $\sigma^2_b$ et la matrice de précision des données s'écrit :

$$Q_P = \frac{I - B_P}{\sigma_b^2} \quad (4)$$

Avec

$$B_P = H_P(H_P{}^T H_P + \alpha D^T D)^{-1} H_P{}^T \quad (5)$$

et

$$\alpha = \frac{\sigma_b^2}{\sigma_x^2} \quad , \quad (6)$$

qui s'interprète comme l'inverse du Rapport Signal-à-Bruit (RSB).

Exemples

1) Modifications du diaphragme pour favoriser l'estimation de profondeur.

Les fonctions d'étalement de point d'un système optique idéal (ie sans aberration) sont simulées à l'aide des formules d'optique ondulatoire. Ce système a une focale de 50 mm et une ouverture de 2, des pixels de taille 7 $\mu$m. Le plan de mise au point est placé à 1.9 m du système électro-optique. La précision d'estimation théorique obtenue dans le cas d'un diaphragme classique est comparée à celle obtenue dans le cas d'un diaphragme codé, tel que celui proposé dans l'article d' A. Levin cité dans l'état de l'art, pour un même rapport signal à bruit.

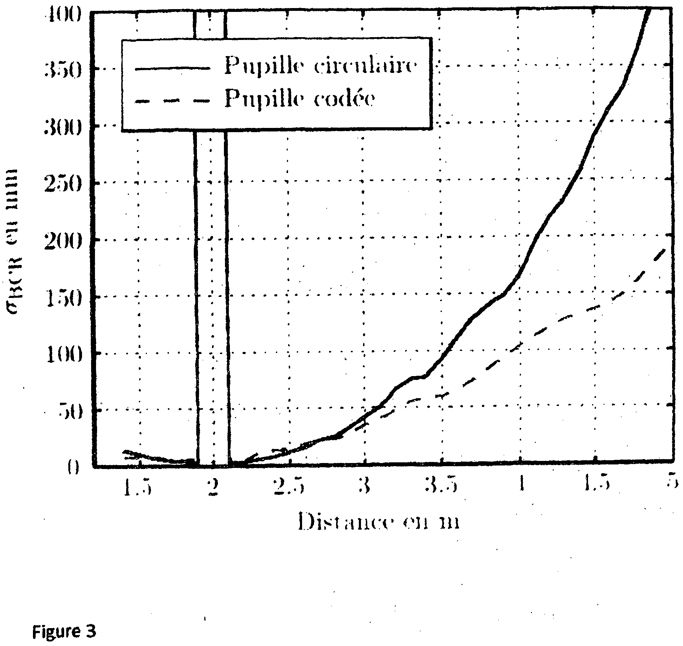

La figure 3 illustre le gain du diaphragme codé par rapport à un diaphragme classique pour l'estimation de profondeur.

Ces courbes permettent de comparer différentes formes de diaphragme pour trouver celle qui favorise l'estimation de profondeur.

2) Modification de la mise au point pour favoriser l'estimation de la profondeur

Les fonctions d'étalement de point d'un système électro-optique idéal autrement dit sans aberration sont simulées à l'aide des formules d'optique ondulatoire. Ce système a une focale de 20 mm et une ouverture de 3, des pixels de taille 7 $\mu$m.

Le plan de mise au point est placé à 1.4 m de l'appareil (courbe verte) et 2 m (courbe bleue). On compare la précision d'estimation théorique $\sigma$BCR obtenue pour les deux mises au point.

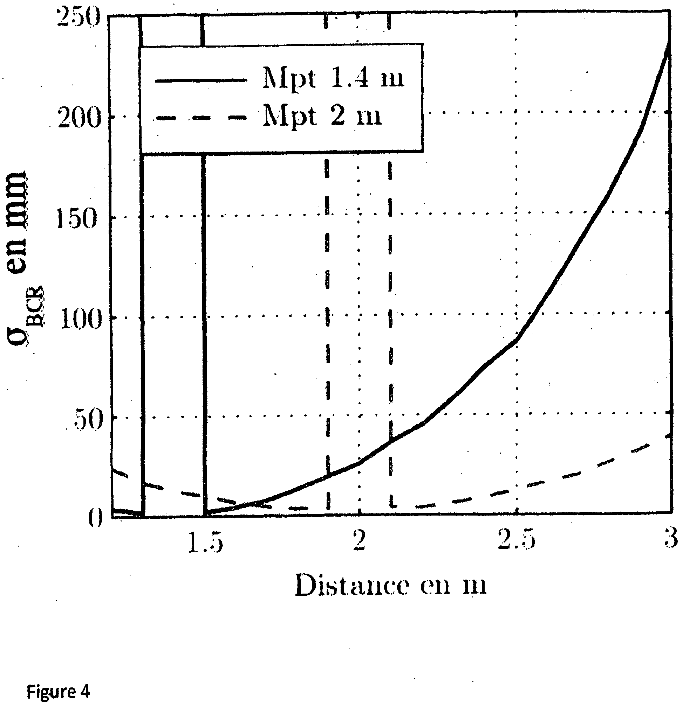

La figure 4 montre que deux mises au point différentes n'ont pas les mêmes courbes de précision d'estimation.

Notamment chacune présente un pic d'imprécision au niveau du plan de mise au point. Ainsi, pour estimer une profondeur entre 0.5 et 1 m il vaut mieux utiliser la mise au point à 1.3 m. De même, pour estimer des distances au-delà de 2.5m, la mise au point à 2 m est plus favorable. Ces courbes permettent d'ajuster la mise au point de l'appareil en fonction de la région de l'espace dans laquelle on veut estimer la profondeur.

3) Modification de la position des plans de mise au point des trois canaux rouge vert bleu dans le cas d'une optique chromatique

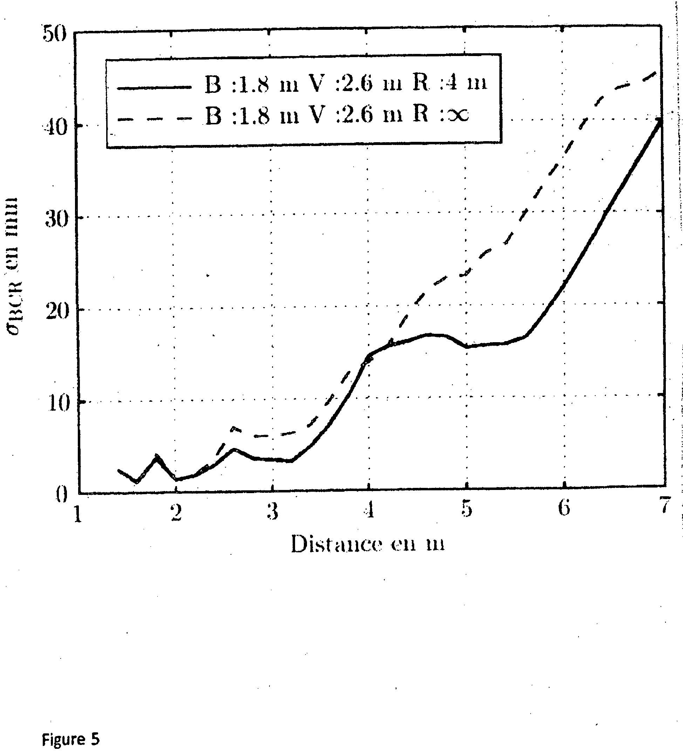

La figure 5 montre les performances d'estimation de profondeur théoriques de deux systèmes électro-optiques chromatiques d'ouverture égale à 3, de focale 25 mm, ayant un détecteur de type tri-CCD avec des pixels de 5 $\mu$m. La mise au point et le chromatisme axial des deux systèmes sont fixés afin d'avoir les plans de mise au point des canaux bleu et vert respectivement à 1.8 m et 2.6 m pour les deux systèmes. Le plan de mise au point du canal rouge est à 4 m pour le premier système et il est à l'infini pour le deuxième système. Les courbes de $\sigma$BCR montrent que le système le plus favorable dans la région de 1 à 5 m est le système ayant une mise au point du canal rouge à 4 m.

4) Optimisation d'un système électro-optique chromatique

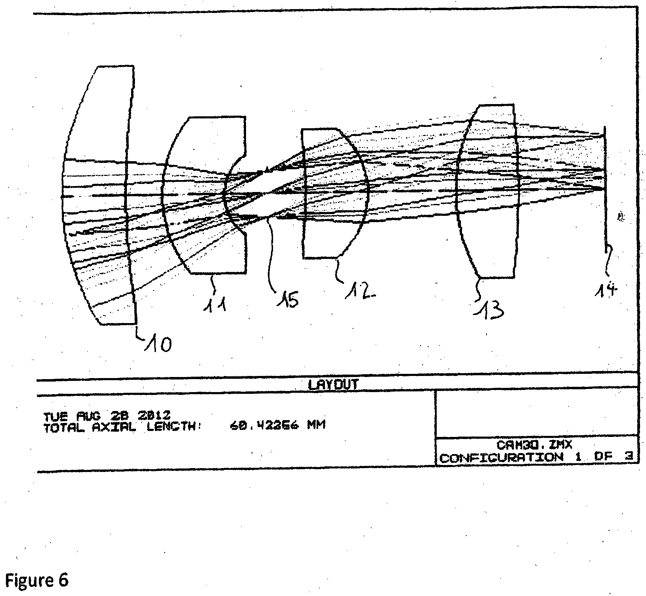

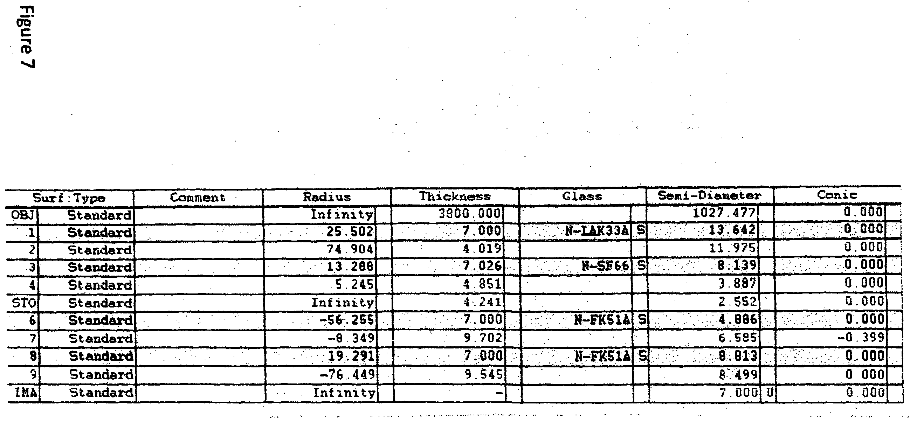

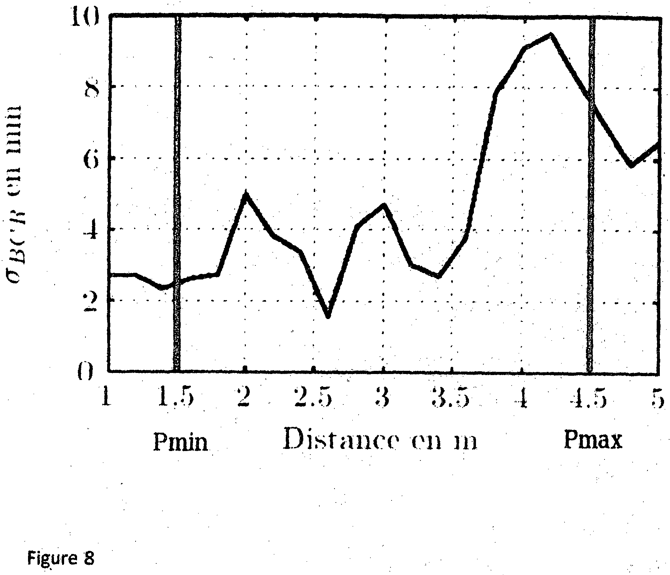

Les figures 6 et 7 présentent les caractéristiques d'un système électro-optique chromatique optimisé en utilisant le procédé illustré dans la figure 2. La figure 8 représente les courbes de $\sigma$BCR de cet imageur sur une plage de profondeur.

Description détaillée du dispositif électro-optique

Le présent exemple concerne un exemple de dispositif optique comportant des moyens d'estimation de la profondeur.

Le dispositif illustré par la figure 6 comprend un objectif constitué dans l'exemple décrit à titre d'exemple non limitatif par quatre lentilles (10 à 13) et un détecteur (14) placé dans le plan focal de l'objectif.

La lentille (13) est de type conique pour corriger certaines aberrations optiques.

Un diaphragme (15) est placé sur le chemin optique de l'objectif. Ce diaphragme est dans l'exemple décrit de type classique, mais il peut aussi être constitué par une diaphragmme codé.

L'invention concerne l'optimisation de cet objectif connu afin de maximiser la précision de l'estimation de profondeur, dans une plage déterminée [$P_{min}$, $P_{max}$] représentée sur la figure 8.

Pour cette optimisation, on peut procéder soit de manière expérimentale et empirique, soit par simulation.

La méthode empirique consiste à générer une pluralité d'objectifs, avec des lentilles de caractéristiques d'indice, de positionnement et de courbures différentes, avec les contraintes suivantes :

- Nombre N de lentilles constant
- Distance focale de l'objectif constante pour une longueur d'onde de référence
- Ouverture de l'objectif constante
- Détecteur inchangé
- le rapport signal à bruit de la source lumineuse observée.

Les paramètres variables sont :

- le rayon de courbure de chacun des N lentilles
- la nature du matériau de chacune des N lentilles (et donc indice)
- la position relative de chacun des N lentilles
- la conicité de la lentille conique (12) lorsqu'une telle lentille est prévue
- la position du détecteur (14)
- la position et la configuration du diaphragme (15).

Pour chacun des montages optiques, on place une source lumineuse ponctuelle à large bande spectrale à une distance p comprise entre $P_{min}$ et $P_{max}$, de préférence sur l'axe optique, et on acquiert au moins une image chromatique produite à l'aide du détecteur (14) à M canaux, cette image étant notée $FEP_m(p)$ pour m=1, ..., M. A titre d'exemple, le détecteur comporte trois canaux « RGB ». Dans l'exemple décrit, M est égal à trois et on acquiert pour un triplet d'images chromatique $FEP_m(p)$, m=R,G,B. Chaque image du triplet permet de calculer une matrice de convolution Hm. A l'aide des M matrices $H_m$ on constitue ensuite une matrice chromatique $H_p$ par l'équation :

$$H_P(p) = \begin{pmatrix} c_{1,1}H_R & c_{1,2}H_R & c_{1,3}H_R \\ c_{2,1}H_G & c_{2,2}H_G & c_{2,3}H_G \\ c_{3,1}H_B & c_{3,2}H_B & c_{3,3}H_B \end{pmatrix}$$

où les $c_{i,j}$, sont les coefficients suivants :

$$C = \begin{pmatrix} \dfrac{1}{\sqrt{3}} & \dfrac{-1}{\sqrt{2}} & \dfrac{-1}{\sqrt{6}} \\ \dfrac{1}{\sqrt{3}} & \dfrac{1}{\sqrt{2}} & \dfrac{-1}{\sqrt{6}} \\ \dfrac{1}{\sqrt{3}} & 0 & \dfrac{2}{\sqrt{6}} \end{pmatrix}$$

Cette matrice $H_p(p)$ sert ensuite à calculer une matrice de précision $Q_p$ telle que décrite dans l'équation (3).

La matrice $Q_x$ est définie par :

$$Q_x = \begin{pmatrix} \mu D^T D & 0 & 0 \\ 0 & D^T D & 0 \\ 0 & 0 & D^T D \end{pmatrix} \quad \text{avec } \mu = 0.05.$$

Où D est la concaténation des opérateurs de dérivation horizontale et verticale d'ordre 1. On procède ensuite à l'acquisition d'un triplet d'images chromatiques supplémentaire correspondant à la même source lumineuse placée à une distance p+Δp. On obtient par la même méthode une matrice de précision $Q_p(p+\Delta p)$.

A partir de ces matrices, on détermine une approximation numérique de l'équation (2) par l'équation

$$\frac{dQ_P}{dp}(p) \approx \frac{Q_P(p + \Delta p) - Q_P(p)}{\Delta p}$$

Cette BCR qualifie le système analysé pour la position de source p.

On renouvelle ce calcul sur une pluralité de profondeur p, pour déterminer pour chacun des montages une courbe des valeurs σBCR(p) en fonction de la distance p de la source, dont la figure 5 donne deux exemples.

L'approximation numérique de la BCR à la position p pourra avantageusement être calculée à partir d'un nombre de mesures S>2 autour de la position p : p+Δp_s, pour s=1,...,S.

La détermination du montage optimal est réalisée par la sélection de celui dont la courbe σBCR est la meilleure. Ce critère peut être déterminé en fonction de la minimisation de la moyenne des points de la courbe, ou de l'intégrale de la courbe ou plus généralement de toute fonction de qualité déduite à partir de la collection de valeurs σBCR.

La figure 8 représente un exemple de courbe sélectionnée et des valeurs afférentes pour la détermination du montage optique représenté en figure 7.

A titre d'alternative, ce processus peut être réalisé de manière virtuelle à partir d'un logiciel de simulation optique de type ZEMAX.

Pour optimiser le chromatisme axial, il est possible de choisir la combinaison de deux lentilles d'indices différentes ou la combinaison d'une lentille réfractive et d'une lentille diffractive. Afin de ne pas être limité par l'efficacité de diffraction de la lentille diffractive sur une large bande spectrale, la combinaison de deux optiques de constringence différente est préférée.

Afin de corriger ensuite le chromatisme latéral et la distorsion, on veille à ce que la position point de l'image soit la même dans le plan XY du détecteur à chaque longueur d'onde et à ce que les barycentres des taches image à chaque longueur d'onde pour un point du champ soient à la même position sur le détecteur.

Il est donc nécessaire de répartir des lentilles de part et d'autre du diaphragme.

Le système optique respecte la contrainte du télécentrisme (l'angle moyen des rayons de champ en sortie de la pupille de sortie arrive perpendiculairement sur le détecteur). Cette propriété assure que les barycentres des taches image à chaque longueur d'onde pour un point du champ seront à la même position sur le détecteur dans le cas d'une défocalisation. Cette contrainte sera prise en compte par la lentille la plus proche du détecteur.

De préférence, le système présente une grande ouverture (dans l'exemple, le système est ouvert à F/3) afin de réduire la profondeur de champ et d'accentuer les variations de flous. Une forte ouverture impose une correction plus importante des aberrations. Pour limiter le nombre de surfaces asphériques pour des raisons de tolérancement, des lentilles sont ajoutées dans l'architecture optique. Afin de limiter l'ouverture des lentilles placées de part et d'autre du diaphragme et donc diminuer l'amplitude des aberrations, il est proposé de dupliquer chacune de ces lentilles. Une autre solution consiste à rajouter une lentille au niveau du diaphragme afin de corriger efficacement l'aberration sphérique. Le système présente alors une architecture à trois lentilles appelée triplet de Cooke. Cette solution ne permet toutefois pas d'avoir accès au diaphragme (pour placer un diaphragme codé par exemple).

L'architecture préférée est constituée de 4 lentilles placées de part et d'autre du diaphragme. Cette architecture est une variante du Rapid rectilinear (page 278 du livre Hansbook of Optical Systems volume 4) ou du double Gauss (page 303 du livre Hansbook of Optical Systems volume 4). Les différences sont dues à l'absence de doublet et de la contrainte de télécentrisme (la quatrième lentille, celle qui est la plus proche du détecteur, s'étant écartée la troisième lentille pour assurer le télécentrisme et la correction de la courbure de champ.

L'optimisation à l'aide d'un logiciel de calcul optique tel que Zemax permet de choisir les rayons de courbures, l'épaisseur et la position de chaque lentille. Les matériaux de chaque lentille sont choisis de manière à produire la bonne quantité de chromatisme axial. Une conicité est ajoutée sur une des surfaces afin de corriger un résiduel d'aberration.

## Revendications

1. Procédé mis en oeuvre par ordinateur pour la conception d'un système d'imagerie électro-optique pour estimer la distance d'une source, incluant un sous-système optique, un sous-système de détecteur et un sous-système de traitement d'image numérique, le procédé incluant la modélisation de la propagation d'un rayonnement depuis sa source par l'intermédiaire du sous-système optique, du sous-système de détecteur et du sous-système de traitement d'image numérique, la modélisation étant basée sur un modèle spatial de la source, le procédé incluant une étape de conception conjointe simultanément du sous-système optique et du sous-système de traitement d'image numérique basée au moins sur une métrique de performance, **caractérisé en ce que** ladite métrique de performance est fonction d'une comparaison entre l'estimation locale de la distance de la source et la distance réelle de la source.

2. Procédé selon la revendication 1 **caractérisé en ce que** ladite fonction de comparaison est réalisée par une moyenne probabiliste du comportement de l'écart entre la distance estimée et la distance réelle sur un catalogue d'images.

3. Procédé selon la revendication 2 **caractérisé en ce que** ledit écart est **caractérisé par** le calcul de la courbure moyenne de la fonction de vraisemblance, vis-à-vis de la profondeur, pour un catalogue d'images. Cette fonction de vraisemblance est calculée suivant les étapes suivantes :

   - enregistrement d'une bibliothèque de fonctions d'étalement de points (FEP), chacune desdites fonctions FEP associée à une profondeur et à un système électro-optique ;
   - capture d'au moins une image réelle, ou modélisation d'au moins une image à l'aide d'une des FEP de la bibliothèque de FEP ;
   - division de ladite (ou desdites) image(s) en vignette(s) de taille prédéfinie pour enregistrer une collection de vignettes;
   - calcul de la vraisemblance de chaque FEP, vis-à-vis du contenu des vignettes et estimation pour chacune desdites vignettes de la fonction d'étalement de points (FEP) qui maximise cette vraisemblance;
   - mesure de la courbure locale du critère de vraisemblance autour de la FEP qui maximise la fonction de vraisemblance.

**4.** Procédé selon la revendication précédente **caractérisé en ce que** ledit critère de vraisemblance est calculé à partir d'un modèle spatial de la source.

**5.** Procédé selon la revendication précédente **caractérisé en ce que** ledit modèle est une densité spectrale de puissance, ou une matrice de covariance apprise sur une base d'images, ou une matrice de précision, fondée sur une distribution isotrope et gaussienne des gradients de la source.

**6.** Procédé selon la revendication 3 **caractérisé en ce que** l'on procède à l'acquisition simultanée, avec des mises au point différentes, et au traitement d'une pluralité d'images.

**7.** Procédé selon la revendication précédente, **caractérisé en ce que** ladite pluralité d'images est obtenue avec un détecteur constitué d'une pluralité de matrices de capteurs sensibles chacune à une bande spectrale spécifique, chacune des images correspondant à l'une desdites bandes spectrales.

**8.** Procédé selon la revendication précédente, **caractérisé en ce que** le système optique présente des moyens d'ajustement d'une mise au point spécifique pour chacune des dites bandes spectrales.

**9.** Procédé selon la revendication 3, **caractérisé en ce que** le sous-système optique inclut un diaphragme codé apte à minimiser l'écart entre la distance estimée et la distance réelle sur un catalogue d'images, le procédé comportant des étapes de variation du codage dudit diaphragme et de détermination de l'écart en découlant.

**10.** Procédé selon la revendication 3 **caractérisé en ce que** les paramètres de l'optique et des traitements sont optimisés en temps réel pour favoriser l'estimation de profondeur, les conditions d'utilisation étant indiquées soit par l'utilisateur soit estimées par des algorithmes appartenant au système électro-optique.

**11.** Procédé selon la revendication 1 **caractérisé en ce que** ladite étape de conception est basée sur la combinaison d'une métrique de performance fonction d'une comparaison entre l'estimation locale de la distance de la source et la distance réelle de la source et d'une métrique caractérisant la capacité de produire également une image de grande profondeur de champ.

**12.** Procédé selon la revendication 1 **caractérisé en ce que** la métrique de performance est comparée à un gabarit fixé par l'utilisateur.

**13.** Procédé selon la revendication 12 **caractérisé en ce que** dans le cas où plusieurs systèmes électro-optiques répondent au gabarit, ces différents systèmes sont proposés à l'utilisateur ainsi que la possibilité de donner plus de contraintes.

**14.** Procédé selon la revendication 12 **caractérisé en ce que** dans le cas où aucun système électro-optique ne répond au gabarit, l'utilisateur est informé afin de réduire les contraintes.

**15.** Dispositif électro-optique comprenant un estimateur de profondeur fonctionnant pour une plage de distance [$P_{min}$, $P_{max}$] **caractérisé en ce qu'**il est constitué par un objectif comprenant N lentilles (10 à 13), un détecteur (14) placé dans le plan focal de l'objectif et un diaphragme (15), les caractéristiques dudit objectif étant déterminé d'après une métrique de performance fonction d'une comparaison entre l'estimation locale de la distance de la source et la distance réelle de la source.

**16.** Dispositif électro-optique selon la revendication précédente **caractérisé en ce que** l'une au moins desdites lentilles (10 à 13) est de type conique.

**Patentansprüche**

**1.** Ein mittels Rechner durchgeführtes Verfahren zur Entwicklung eines elektrooptischen Bildgebungsverfahrens zur Entfernungsschätzung einer Strahlenquelle, das ein optisches Teilsystem, ein Detektionsteilsystem und ein Teilsystem zur digitalen Bildverarbeitung umfasst, wobei das Verfahren die Modellierung der Ausbreitung einer Strahlung von ihrer Quelle aus über das optische Teilsystem, das Detektionsteilsystem und das Teilsystem zur digitalen Bildverarbeitung umfasst und die Modellierung auf einem räumlichen Modell der Strahlenquelle beruht, wobei das Verfahren eine auf mindestens einer Leistungskennzahl beruhende gemeinsame Gestaltungsphase des optischem Teilsystems und des Teilsystems der digitalem Bildverarbeitung zusammen umfasst, **dadurch gekennzeichnet, dass** besagte Leistungskennzahl abhängt von einem Vergleich zwischen der lokalen geschätzten Entfernung der Strahlenquelle und der tatsächlichen Entfernung der Strahlenquelle.

2.  Verfahren nach Anspruch 1, **dadurch gekennzeichnet, dass** besagte Vergleichsfunktion über das probabilistische Mittel des Verhaltens der Abweichung zwischen der geschätzten und der tatsächlichen Entfernung an einem Bilderkatalog durchgeführt wird.

3.  Verfahren nach Anspruch 2, **dadurch gekennzeichnet, dass** besagte Abweichung bei einem Bilderkatalog durch die Berechnung der Durchschnittskrümmung der Wahrscheinlichkeitsfunktion in Bezug auf die Tiefe gekennzeichnet ist. Diese Wahrscheinlichkeitsfunktion wird in folgenden Schritten berechnet:

    - Speicherung einer Bibliothek von Punktverteilungsfunktionen, wobei jede der besagten Punktverteilungsfunktionen mit einer Tiefe und einem elektrooptischen System verknüpft ist.
    - Erfassung von mindestens einem tatsächlichen Bild, oder Modellierung von mindesten einem Bild mithilfe der Punktverteilungsfunktionen der entsprechenden Bibliothek.
    - Unterteilung des (oder der) besagten Bilder in Miniaturbilder vordefinierter Größe, um eine Miniaturbildsammlung zu speichern.
    - Berechnung der Wahrscheinlichkeit jeder Punktverteilungsfunktion in Bezug auf den Inhalt der Miniaturbilder und bei jedem der besagten Miniaturbilder Bestimmung der Punktverteilungsfunktion, die diese Wahrscheinlichkeit maximiert.
    - Messung der lokalen Krümmung des Wahrscheinlichkeitskriteriums in der Punktverteilungsfunktion, die die Wahrscheinlichkeitsfunktion maximiert.

4.  Verfahren nach dem vorhergehenden Anspruch, **dadurch gekennzeichnet, dass** besagtes Wahrscheinlichkeitskriterium ausgehend von einem räumlichen Modell der Strahlenquelle berechnet wird.

5.  Verfahren nach dem vorhergehenden Anspruch, **dadurch gekennzeichnet, dass** das besagte Modell eine spektrale Leistungsdichte oder eine auf der Grundlage von Bildern erlernte Kovarianz-Matrize oder eine auf einer isotropen Gaußschen Verteilung der Gradienten der Quelle beruhende Genauigkeitsmatrix ist.

6.  Verfahren nach Anspruch 3, **dadurch gekennzeichnet, dass** mehrere Bilder gleichzeitig mit unterschiedlicher Fokussierung erfasst und verarbeitet werden.

7.  Verfahren nach dem vorhergehenden Anspruch, **dadurch gekennzeichnet, dass** besagte Bildervielzahl erzielt wird durch einem Detektor, der aus einer Anordnung empfindlicher Sensoren besteht, wobei jeder ein spezifisches Spektralband aufweist, und jedes der Bilder einem der Spektralbänder entspricht.

8.  Verfahren nach dem vorhergehenden Anspruch, **dadurch gekennzeichnet, dass** das optische System Mittel zur Einstellung einer spezifischen Fokussierung für jedes dieser Spektralbänder aufweist.

9.  Verfahren nach Anspruch 3, **dadurch gekennzeichnet, dass** das optische Teilsystem eine kodierte Blende umfasst, welche die Abweichung zwischen der geschätzten Entfernung und der tatsächlichen Entfernung in einem Bilderkatalog minimiert, wobei das Verfahren die Veränderung der Codierung besagter Blende und die Bestimmung der daraus resultierenden Abweichungen umfasst.

10. Verfahren nach Anspruch 3, **dadurch gekennzeichnet, dass** die Parameter von Optik und Verarbeitung in Echtzeit optimiert werden, um die Abschätzung der Tiefe zu begünstigen, wobei die Benutzungsbedingungen entweder vom Benutzer angegeben oder durch Algorithmen des elektrooptischen Systems bestimmt werden.

11. Verfahren nach Anspruch 1, **dadurch gekennzeichnet, dass** besagter Gestaltungsschritt auf der Kombination einer Leistungskennzahl in Abhängigkeit von einem Vergleich zwischen der lokalen geschätzten Entfernung der Strahlenquelle und der tatsächlichen Entfernung der Strahlenquelle, mit einer Kennzahl beruht, welche die Fähigkeit kennzeichnet, ein Bild mit großer Schärfentiefe herstellen zu können.

12. Verfahren nach Anspruch 1, **dadurch gekennzeichnet, dass** die Leistungskennzahl verglichen wird mit einer Vorgabe des Benutzers.

**13.** Verfahren nach Anspruch 12, **dadurch gekennzeichnet, dass** wenn mehrere elektrooptische Systeme die Vorgaben erfüllen, dem Benutzer die einzelnen Systeme sowie die Möglichkeit, weitere Auflagen festzulegen, vorgeschlagen werden.

**14.** Verfahren nach Anspruch 12, **dadurch gekennzeichnet, dass** wenn kein elektrooptisches System der Vorgabe entspricht, der Benutzer darüber informiert wird, um die Auflagen zu mindern.

**15.** Elektrooptische Vorrichtung mit einer im Entfernungsbereich [$P_{min}/P_{max}$] funktionierenden Tiefenschätzfunktion, **dadurch gekennzeichnet, dass** sie aus einem Objektiv mit N Linsen (10 bis 13), einem auf der Fokalebene des Objektivs positionierten Detektor (14) und einer Blende (15) besteht, wobei die Merkmale besagten Objektivs einer Leistungskennzahl zufolge festgelegt werden, die von einem Vergleich der lokalen Schätzung der Entfernung der Strahlenquelle mit der tatsächlichen Entfernung der Quelle abhängt.

**16.** Elektrooptische Vorrichtung nach dem vorhergehenden Anspruch, **dadurch gekennzeichnet, dass** mindestens eine der besagten Linsen (10 bis 13) eine konische Linsen ist.

**Claims**

**1.** A computer-implemented method for designing an electro-optical imaging system for estimating the distance of a source, including an optical sub-system, a detector sub-system and a digital image processing sub-system, with the method including the modelling of the propagation of radiation from its source through the optical sub-system, the detector sub-system and the digital image processing sub-system, with the modelling being based on a spatial model of the source, with the method including a joint step of simultaneously designing the optical sub-system and the digital image processing sub-system, based on at least one performance metric, **characterized in that** said performance metric depends on a comparison between the local estimation of the distance from the source and the actual distance from the source.

**2.** A method according to claim 1, **characterized in that** said comparison function is performed by a probabilistic average of the behavior of the difference between the estimated distance and the actual distance on a catalog of images.

**3.** A method according to claim 2, **characterized in that** said difference is **characterized by** calculating the mean curvature of the likelihood function, relative to the depth, for a catalog of images. This likelihood function is calculated according to the following steps:

- saving a library of point spread functions (PSF), with each one of said PSF functions being associated with a depth and with an electro-optical system;
- capturing at least one real image, or modelling at least one image using one of the PSFs from the PSF library;
- dividing said image(s) into thumbnail(s) having a predefined size to save a thumbnail collection;
- calculating the likelihood of each PSF, relative to the content of the thumbnails and estimating, for each of said thumbnails, the point spread function (PSF) that maximizes this likelihood;
- measuring the local curvature of the likelihood criterion around the PSF that maximizes the likelihood function.

**4.** A method according to the preceding claim, **characterized in that** said likelihood criterion is calculated from a spatial model of the source.

**5.** A method according to the preceding claim, **characterized in that** said model is a power spectral density, or a covariance matrix learnt on an image database, or an accuracy matrix, based on an isotropic and Gaussian distribution of the source gradients.

**6.** A method according to claim 3, **characterized in that** the acquisition, with different focusing, and the processing of a plurality of images are simultaneous carried out.

**7.** A method according to the preceding claim, **characterized in that** said plurality of images is obtained with a detector comprising a plurality of matrices of sensors, each one being sensitive to a specific spectral band, with each image corresponding to one of said spectral bands.

8. A method according to the preceding claim, **characterized in that** the optical system has means for adjusting a specific focus for each one of said spectral bands.

9. A method according to claim 3, **characterized in that** the optical sub-system includes an encoded diaphragm capable of minimizing the difference between the estimated distance and the actual distance on a catalog of images, with the method comprising steps of variation of the encoding of said diaphragm and of determination of the difference arising therefrom.

10. A method according to claim 3, **characterized in that** the optics and the processing parameters are optimized in real time to facilitate the estimation of depth, with the conditions of use being indicated either by the user or estimated by algorithms belonging to the electro-optical system.

11. A method according to claim 1, **characterized in that** said step of designing is based on the combination of a performance metric depending on a comparison between the local estimation of the distance from the source and the actual distance from the source and a metric characterizing the ability to also produce an image having a large depth of field.

12. A method according to claim 1, **characterized in that** the performance metric is compared to a template set by the user.

13. A method according to claim 12, **characterized in that**, in the case where several electro-optical systems comply with the template, such different systems are proposed to the user as well as the possibility of imparting more constraints.

14. A method according to claim 12, **characterized in that**, in the case where no electro-optical system complies with the template, the user is notified so as to reduce the constraints.

15. An electro-optical device comprising a depth estimator operative for a distance range [$P_{min}$, $P_{max}$] **characterized in that** it consists of an objective comprising N lens (10 to 13), a detector (14) positioned in the focal plane of the objective and a diaphragm (15), with the characteristics of said objective being determined from a performance metric depending on a comparison between the local estimation of the distance from the source and the actual distance from the source.

16. An electro-optical device according to the preceding claim, **characterized in that** at least one of said lenses (10 to 13) is of the conical type.

Figure 1

Figure 2

Figure 3

Figure 4

Figure 5

LAYOUT

TUE AUG 28 2012
TOTAL AXIAL LENGTH:     60.42366 MM

CAM3Q.ZMX
CONFIGURATION 1 OF 3

Figure 6

**Figure 7**

| Surf:Type | Comment | Radius | Thickness | Glass | | Semi-Diameter | Conic |
|---|---|---|---|---|---|---|---|
| OBJ Standard | | Infinity | 3800.000 | | | 1027.477 | 0.000 |
| 1 Standard | | 25.502 | 7.000 | N-LAK33A | S | 13.642 | 0.000 |
| 2 Standard | | 74.904 | 4.019 | | | 11.975 | 0.000 |
| 3 Standard | | 13.208 | 7.026 | N-SF66 | S | 8.139 | 0.000 |
| 4 Standard | | 5.245 | 4.851 | | | 3.887 | 0.000 |
| STO Standard | | Infinity | 4.241 | | | 2.552 | 0.000 |
| 6 Standard | | -56.255 | 7.000 | N-FK51A | S | 4.886 | 0.000 |
| 7 Standard | | -8.349 | 9.702 | | | 6.585 | -0.399 |
| 8 Standard | | 19.291 | 7.000 | N-FK51A | S | 8.813 | 0.000 |
| 9 Standard | | -76.449 | 9.545 | | | 8.499 | 0.000 |
| IMA Standard | | Infinity | - | | | 7.000 U | 0.000 |

Figure 8

## RÉFÉRENCES CITÉES DANS LA DESCRIPTION

**Documents brevets cités dans la description**

- US 7711201 B
- FR 2880958
- WO 2009082822 A
- WO 2007022329 A
- US 2009268985 A
- EP 1734746 A
- FR 2919732

**Littérature non-brevet citée dans la description**

- **A. LEVIN ; R. FERGUS ; F. DURAND ; W.T. FREE-MAN.** Image and depth from a conventional camera with a coded aperture ACM Transactions on Graphics. *SIGGRAPH,* 2007, http://groups.csail.mit.edu/graphics/CodedAperture/CodedApert ure-LevinEtAl-SIGGRAPH07.pdf
- Performance analysis of maximum likelihood estimator for recovery of depth from defocused images and optimal selection of camera parameters. **A.RAJAGOPALAN ; S.CHAUDHURI.** International Journal of Computer Vision. Springer, 1998, vol. 30, 175-190
- Hansbook of Optical Systems. vol. 4, 278
- Hansbook of Optical Systems. vol. 4, 303